(19) **Europäisches Patentamt / European Patent Office / Office européen des brevets**

(11) **EP 3 631 357 B1**

(12) **FASCICULE DE BREVET EUROPEEN**

(45) Date de publication et mention de la délivrance du brevet:
**17.09.2025 Bulletin 2025/38**

(51) Classification Internationale des Brevets (IPC):
**G01B 11/16** *(2006.01)* **G01B 11/24** *(2006.01)*
**G01N 21/17** *(2006.01)* **G01B 11/25** *(2006.01)*
**H01L 21/66** *(2006.01)*

(21) Numéro de dépôt: **18724590.7**

(22) Date de dépôt: **23.05.2018**

(52) Classification Coopérative des Brevets (CPC):
**G01B 11/24; G01B 11/167; G01B 11/25;**
**G01B 11/2513; G01B 11/2522;** H01L 22/12

(86) Numéro de dépôt international:
**PCT/EP2018/063441**

(87) Numéro de publication internationale:
**WO 2018/215507 (29.11.2018 Gazette 2018/48)**

(54) **PROCEDE DE MESURE DE LA COURBURE D'UNE SURFACE REFLECHISSANTE ET DISPOSITIF OPTIQUE ASSOCIE**

VERFAHREN ZUR MESSUNG DER KRÜMMUNG EINER REFLEKTIERENDEN OBERFLÄCHE UND ZUGEHÖRIGE OPTISCHE VORRICHTUNG

METHOD FOR MEASURING THE CURVATURE OF A REFLECTIVE SURFACE AND ASSOCIATED OPTICAL DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.05.2017 FR 1754616**

(43) Date de publication de la demande:
**08.04.2020 Bulletin 2020/15**

(73) Titulaire: **Centre National de la Recherche Scientifique**
**75016 Paris (FR)**

(72) Inventeurs:
- **ARNOULT, Alexandre**
  **31320 Auzeville-Tolosane (FR)**
- **COLIN, Jonathan**
  **31770 Colomiers (FR)**

(74) Mandataire: **Atout PI Laplace**
**Immeuble Up On**
**25 Boulevard Romain Rolland**
**CS 40072**
**75685 Paris Cedex 14 (FR)**

(56) Documents cités:
WO-A1-2015/135952 WO-A1-2015/135952
WO-A1-2016/018260 FR-A1- 2 842 591
FR-A1- 2 842 591 US-A1- 2007 146 685
US-A1- 2007 146 685 US-A1- 2009 190 139
US-A1- 2009 190 139 US-A1- 2012 002 213
US-A1- 2012 002 213 US-B2- 9 070 590
US-B2- 9 138 790

- J P CHAMBARD ET AL: "Comptes Rendus des JNC 16 ? Toulouse 2009 to composite structures -", 20 May 2009 (2009-05-20), XP055107721, Retrieved from the Internet <URL:http://hal.archives-ouvertes.fr/docs/00/38/57/70/PDF/126b.pdf> [retrieved on 20140313]
- J P CHAMBARD ET AL: "Comptes Rendus des JNC 16 &#xF8E7; Toulouse 2009 to composite structures -", 20 May 2009 (2009-05-20), XP055107721, Retrieved from the Internet <URL:http://hal.archives-ouvertes.fr/docs/00/38/57/70/PDF/126b.pdf> [retrieved on 20140313]

EP 3 631 357 B1

## Description

Le domaine de l'invention est celui des dispositifs optiques de mesure de déformations de surfaces réfléchissantes. Ces dispositifs de mesures peuvent notamment être utilisés pour mesurer la déformation de plaquettes de semi-conducteur appelées également « wafer ». Le dispositif de mesure selon l'invention permet le contrôle de la plaquette pendant les opérations de dépôts de couches de matériaux nécessaires à la réalisation de composants électroniques. Le dispositif de mesure permet également le contrôle après dépôt desdites plaquettes ou le suivi ou le contrôle ex-situ de n'importe quel type de traitement de matériaux engendrant une déformation de la plaquette.

Lorsque l'on réalise des opérations de dépôts sous vide de couches de matériaux sur une plaquette de semi-conducteur, par exemple, par épitaxie par jets moléculaires, des contraintes se développent dans la couche déposée et induisent des contraintes mécaniques dans la plaquette. Généralement, les plaquettes ont des épaisseurs assez faibles, variant typiquement entre 100 microns et 700 microns. Sous l'effet des contraintes subies, elles peuvent se déformer de façons plus ou moins importantes. La connaissance de ces déformations renseigne donc sur l'importance, la nature et la localisation des contraintes permettant de déterminer si le dépôt en cours se déroule correctement ou non et de remonter aux mécanismes atomistiques à l'origine de ces contraintes.

Les plaquettes sont généralement réfléchissantes. Pour mesurer les déformations, on utilise cette propriété et les dispositifs de mesure utilisés sont des dispositifs optiques. Tous ces dispositifs comportent une source de lumière de géométrie connue et un récepteur. La source de lumière et le récepteur sont disposés de sorte que, la lumière émise par la source soit observable par le récepteur au travers de la surface réfléchissante. Le récepteur perçoit donc l'image de la source au travers de la surface de la plaquette. Si la plaquette est un miroir plan parfait, cette image n'est pas déformée, aux incertitudes du système de mesure près. Si la plaquette se déforme sous l'action d'une contrainte, l'image de la source se déforme. La mesure de cette déformation permet de déterminer la déformation de la plaquette réfléchissante.

Généralement, les sources sont de forme géométrique simple ou sont constituées de points lumineux disposés selon une géométrie connue. La génération des points lumineux peut être réalisée, par exemple, par un faisceau laser se réfléchissant une pluralité de fois à l'intérieur d'une lame à faces planes et parallèles. La pluralité des faisceaux parallèles transmis constitue le motif d'éclairage. Le brevet US 5 912 738 intitulé « Measurement of the curvature of a surface using parallel light beams » décrit un tel dispositif de mesure. Le brevet US 9 070 590 intitulé « Workpiece breakage prevention method and apparatus » décrit un autre type de dispositif de mesure dans une application différente de celle de la mesure des caractéristiques des wafers, le dispositif mesurant des contraintes thermiques.

Une des contraintes de ce type de dispositif de mesure est que le dépôt se fait à l'intérieur d'un bâti sous vide dans laquelle il est, bien entendu, impossible d'introduire des éléments optiques. Dans ce cas, l'émission et la réception de lumière se font nécessairement à l'extérieur du bâti, au travers de hublots transparents. Or, la plaquette peut être de dimensions importantes. Il existe ainsi des wafers dont le diamètre est de 250 millimètres. Pour contrôler une plaquette de cette taille, il serait possible de déplacer la source de lumière et le récepteur pour réaliser différentes mesures mais on comprend que toute la difficulté serait alors de conserver la précision et la qualité de la mesure, sachant que le contrôle doit s'effectuer en temps réel de façon à pouvoir agir si les opérations de dépôt se déroulent mal. De plus, dans la plupart des cas, ces mouvements visant à déplacer la source de lumière sont difficiles ou impossibles à effectuer à cause de la taille réduite des hublots.

Le document FR2842591 décrit un dispositif pour mesurer des variations dans le relief d'un objet diffusant à partir de la projection sur sa surface d'un mouchetis dont les grains sont répartis aléatoirement.

Le document WO2016/018260 décrit un dispositif de caractérisation d'une surface tridimensionnelle, qui peut être réfléchissante, en projetant un motif prédéterminé sur la surface de l'objet.

Le document US9138790 décrit décrit une méthode pour mesurer la planéité d'une feuille de matériau en mouvement selon une direction longitudinale horizontale, en projetant un motif sur la surface de la feuille.

Le document US 2007/146685 décrit une méthode de caractérisation d'un échantillon avec la projection d'un « pattern' » tel un réseau sur l'échantillon à caractériser.

Le procédé de mesure selon l'invention et le dispositif de mesure associé ne présentent pas les inconvénients précités. Ils reposent sur le fait qu'il est possible de déplacer la zone éclairée de la surface réfléchissante, y compris pour des surfaces de grande dimension sans déplacer le récepteur. Plus précisément, l'invention a pour premier objet un procédé de mesure de la déformation d'au moins une surface réfléchissante d'un objet par un dispositif de mesure, ledit dispositif de mesure comprenant au moins un motif d'éclairage comprenant des points lumineux, une caméra et un dispositif d'analyse d'images, le motif d'éclairage et la caméra étant agencés de façon qu'en position de mesure de la déformation de ladite surface, l'image virtuelle ou réelle du motif d'éclairage soit visible par le détecteur de la caméra au travers de la surface, ladite image étant représentative de la déformation de la zone éclairée de la surface par le motif d'éclairage, tel que le procédé de réalisation d'une mesure comporte les étapes suivantes :

   Etape 1 : Mesure d'au moins une distance entre les images de deux points lumineux ;

Etape 2 : Calcul du rapport entre cette distance mesurée à au moins une distance de référence ;

Etape 3 : Calcul, à partir de ce rapport, du grandissement dans une direction déterminée ;

Etape 4 : Calcul de la déformation de la surface réfléchissante dans ladite direction déterminée

Selon l'invention, le procédé comporte une cinquième étape dans laquelle les étapes 1 à 4 sont réalisées pour une pluralité d'images de points lumineux de façon à mesurer le grandissement dans une pluralité de directions données et à calculer l'anisotropie de la déformation de la surface réfléchissante, une image finale permettant une détermination d'information d'anisotropie dans deux directions orthogonales, ladite pluralité d'images finales étant réalisées selon une pluralité de positions angulaires dudit objet décrivant une rotation complète dudit objet, de manière à déterminer un ou des axes d'anisotropie de la déformation de ladite surface.

Avantageusement, le motif d'éclairage comporte un ensemble de points lumineux discrets répartis sur une matrice. Selon un mode non revendiqué, un motif d'éclairage comporte au moins un cercle ou une ellipse lumineux, la mesure étant effectuée sur les images de points appartenant à ce cercle ou à cette ellipse lumineux.

Avantageusement, le procédé comporte une étape de réalisation d'au moins une seconde mesure, cette seconde mesure comportant l'émission d'un second motif d'éclairage, lesdits moyens de réalisation des deux mesures étant agencés de façon que le premier motif d'éclairage associé à la première mesure éclaire une première zone de la surface différente de la seconde zone de la surface éclairée par le second motif d'éclairage associé à la seconde mesure, la caméra étant fixe entre les deux mesures.

L'invention a pour second objet un dispositif de mesure de la déformation selon la revendication 3.

Avantageusement, le dispositif comporte des moyens de réalisation d'au moins deux mesures, chaque mesure comportant l'émission d'un motif d'éclairage, lesdits moyens de réalisation des deux mesures étant agencés de façon que le premier motif d'éclairage associé à la première mesure éclaire une première zone de la surface différente de la seconde zone de la surface éclairée par le second motif d'éclairage associé à la seconde mesure, la caméra étant fixe entre les deux mesures.

Avantageusement, le dispositif de mesure comporte des moyens de déplacement, de déformation ou de grandissement du motif d'éclairage.

Avantageusement, le dispositif de mesure comporte en outre des moyens de déplacement en translation de l'objet dans un plan déterminé et des moyens de mesure dudit déplacement.

Avantageusement, le dispositif de mesure comporte un écran de visualisation et des moyens de génération graphique dudit motif d'éclairage sur ledit écran de visualisation.

Avantageusement, le motif d'éclairage est une matrice de points lumineux discrets.

Dans un mode non revendiqué, un motif d'éclairage est un cercle lumineux ou une ellipse lumineuse ou une série de cercles lumineux ou d'ellipses lumineuses.

Avantageusement, le dispositif de mesure comporte une source d'éclairage éclairant un écran opaque comportant des ouvertures agencées de façon à former un motif d'éclairage.

Avantageusement, le dispositif de mesure comporte un séparateur optique plan semi-réfléchissant agencé de façon que l'image du motif de points, après transmission par ledit séparateur optique, réflexion sur la surface et réflexion sur ledit séparateur optique se forme sur le détecteur de la caméra ou après réflexion sur ledit séparateur optique, réflexion sur la surface et transmission par ledit séparateur optique se forme sur le détecteur de la caméra.

Avantageusement, le dispositif de mesure comporte des moyens de réalisation d'une pluralité de mesures réalisant une cartographie complète de la déformation de ladite surface.

Avantageusement, le rayon de courbure local, concave ou convexe, des déformations varie entre quelques millimètres et quelques dizaines de kilomètres.

Avantageusement, l'objet est une plaquette de semi-conducteur ou « wafer », la surface réfléchissante étant l'une des faces de ladite plaquette.

L'invention concerne également l'utilisation d'un dispositif de mesure tel que défini ci-dessus pour la mesure d'une surface réfléchissante concave, caractérisé en ce que le motif d'éclairage et la caméra sont disposés de sorte que l'image du motif d'éclairage réfléchie par la surface réfléchissante concave soit située au voisinage de la lentille de la caméra.

Avantageusement, le dispositif est utilisé pour le suivi d'un traitement entraînant une déformation de la surface réfléchissante d'un objet dans un bâti de croissance, caractérisé en ce que les mesures sont effectuées pendant le dépôt d'au moins une couche de matériau sur ladite surface réfléchissante.

Avantageusement, le dispositif est utilisé pour le contrôle de plaquettes de semi-conducteurs, caractérisé en ce que les mesures sont effectuées en continu sur au moins deux objets différents.

L'invention sera mieux comprise et d'autres avantages apparaîtront à la lecture de la description qui va suivre donnée à titre non limitatif et grâce aux figures annexées parmi lesquelles :

La figure 1 présente un premier mode de réalisation du dispositif de mesure selon l'invention, le dispositif comportant un plateau tournant ;
Les figures 2 et 3 illustrent le principe de la mesure optique des déformations de la plaquette ;

La figure 4 présente un second mode de réalisation du dispositif de mesure selon l'invention, le dispositif comportant un écran de visualisation comme motif d'éclairage ;

La figure 5 présente une variante de ce second mode de réalisation du dispositif de mesure selon l'invention ;

Les figures 6 et 7 présentent un troisième mode de réalisation du dispositif de mesure selon l'invention et une variante de ce dit mode de réalisation ;

La figure 8 présente un quatrième mode de réalisation ;

La figure 9 représente un mode de réalisation du dispositif selon l'invention adapté à la mesure des surfaces réfléchissantes concaves ;

La figure 10 représente les variations du grandissement en fonction du rayon de courbure de la surface réfléchissante ;

Les figures 11 et 12 représentent un motif d'éclairage comportant des cercles concentriques et son image par une surface réfléchissante courbe.

Comme il a été dit, le dispositif de mesure peut être utilisé pour mesurer les déformations d'une surface réfléchissante d'un objet. Il est particulièrement bien adapté à la mesure de déformation de plaquettes de semi-conducteur. Les exemples qui suivent sont tous dans ce domaine technique sans qu'il puisse être considéré comme restrictif.

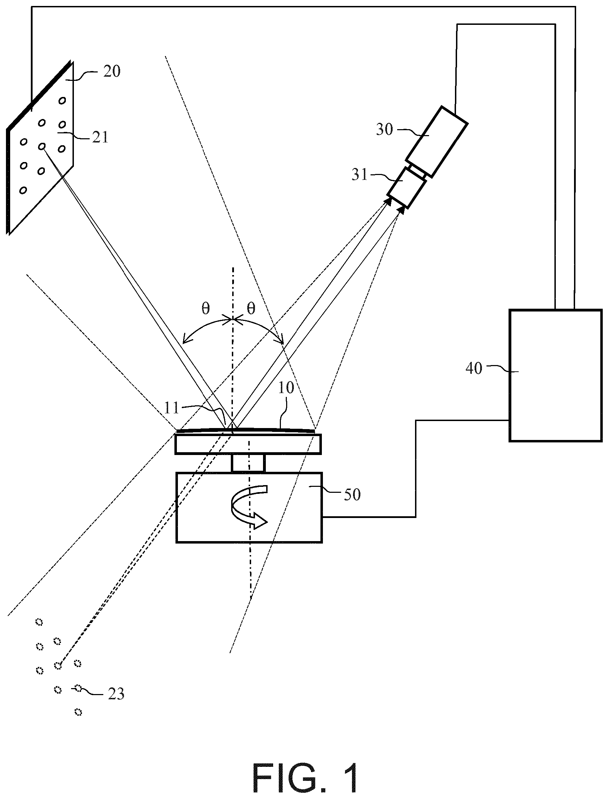

A titre de premier exemple non limitatif, la figure 1 représente un premier mode de réalisation du dispositif de mesure selon l'invention des déformations d'une plaquette 10. Sur ces figures et sur les suivantes, la plaquette est représentée par un arc de cercle épais de façon à illustrer les déformations. On a également représenté en pointillés fins le cheminement des rayons lumineux issus d'un point particulier du motif d'éclairage et en pointillés larges le champ couvert par l'objectif de la caméra.

Généralement, les plaquettes ont une épaisseur comprise entre 100 microns et 700 microns. Leur diamètre est généralement compris entre 25 millimètres et 250 millimètres. Le dispositif de mesure peut mesurer, en adaptant sa configuration, des déformations dont le rayon de courbure local, concave ou convexe, varie entre quelques millimètres et quelques dizaines de kilomètres. Les substrats sont, par exemple, en arséniure de gallium.

Le dispositif de mesure comporte des moyens 20 permettant de créer un motif d'éclairage 21 de forme connue. Il est possible de réaliser ce motif à partir de composants discrets tels que des sources d'éclairage éclairant des symboles transparents percés dans un écran opaque. On peut également utiliser des écrans de visualisation sur lesquels on affiche le motif d'éclairage. Dans ce cas, il devient facile de modifier le motif d'éclairage ou de le dupliquer ou de le déplacer sur l'écran de visualisation ou encore de modifier sa luminance ou sa couleur.

Il peut être intéressant, pour limiter la lumière parasite, d'utiliser un rayonnement monochromatique ou spectralement limité. Dans ce cas, le récepteur photosensible est muni d'un filtre spectral qui transmet uniquement le rayonnement d'émission.

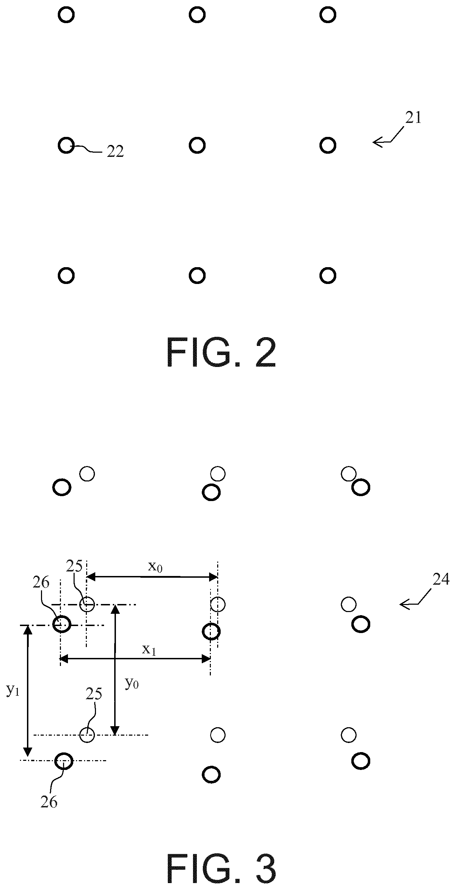

Le motif géométrique d'éclairage est généralement constitué de points lumineux qui peuvent être structurés sous forme de matrice. A titre d'exemple, la figure 3 représente un réseau de ce type comportant 9 points lumineux 22 disposés sur une matrice comportant 3 colonnes et 3 lignes. Sur cette figure 3, les points lumineux sont représentés par des disques. L'utilisation de points lumineux facilite le traitement du signal, comme on le verra. On peut utiliser, pour obtenir plus de précisions, des matrices comportant plus de points. L'augmentation du nombre de points lumineux augmente la précision des mesures mais allonge d'autant les temps de traitement des images. Or, pour certaines applications, il est intéressant de travailler en temps réel avec un nombre de points lumineux limité.

A titre d'exemple, le diamètre des points lumineux est d'environ 500 microns et la distance entre deux points de l'ordre de quelques millimètres.

Lorsque le dispositif de mesure est utilisé avec une enceinte à vide, le motif d'éclairage est en dehors de l'enceinte. La distance séparant le motif d'éclairage de la plaquette est de l'ordre de quelques dizaines de centimètres. Le dispositif de mesure peut fonctionner avec différents angles d'inclinaison $\theta$ entre une droite joignant le centre du motif d'éclairage et le centre de la zone éclairée et la normale à la surface de la plaquette. Toutefois, si l'on souhaite faire fonctionner le dispositif de mesure en incidence normale ou quasi-normale, il est nécessaire de l'adapter comme on le verra dans la suite de la description de façon à séparer la voie d'émission de la voie de réception.

L'un des avantages du dispositif selon l'invention est qu'il peut fonctionner quel que soit l'angle d'inclinaison. Il est important de noter que la sensibilité du dispositif augmente avec l'angle d'inclinaison $\theta$. Elle varie, en première approximation, avec l'inverse du cosinus de l'angle d'inclinaison dans le cas de courbure faible et est donc maximale en incidence rasante. Il est donc avantageux d'utiliser des angles d'inclinaison élevés. La seule limite est que, lorsque l'angle d'inclinaison augmente, la projection du motif d'éclairage sur la surface réfléchissante couvre une surface réfléchissante de plus en plus importante. Typiquement, pour tirer parti de cet avantage, l'angle d'inclinaison peut être dans une plage angulaire comprise entre 60 degrés et 89 degrés.

La plaquette forme par réflexion une image 23 du motif d'éclairage 21 représentée en pointillés sur la figure 1 et les suivantes.

Le dispositif de mesure comporte également un récepteur photosensible 30. Il s'agit d'une caméra. Elle comporte un objectif 31 dont la focale est de quelques centimètres et une matrice de photorécepteurs non représentée sur les différentes figures. On peut utiliser, par exemple, un objectif dont la focale vaut 50 millimètres ou 100 millimètres. L'ouverture de cet objectif définit classiquement la profondeur de champ. Il n'est pas nécessaire que la matrice de photorécepteurs ait une résolution élevée. Comme on le voit sur la figure 1, l'axe optique de la caméra est disposé de façon que l'image finale 24 de l'image 23 du motif d'éclairage réfléchie par la plaquette se trouve sensiblement au centre du champ de la caméra. La caméra occupe donc une position symétrique de celle du motif d'éclairage par rapport à la normale à la surface de la plaquette. Le champ de vision de la caméra munie de son objectif doit permettre de voir la totalité de l'image du motif. Comme il a été dit, l'optique de la caméra peut comporter un filtrage spectral adapté à la bande spectrale d'émission du motif d'éclairage de façon à réduire la lumière parasite.

Pour un motif d'éclairage 21 tel que représenté sur la figure 2 et comportant neuf points lumineux 22, on obtient, au final, après réflexion sur la plaquette et focalisation par l'objectif 31 une image 24 représentée sur la figure 3. Elle comporte neuf points lumineux représentés par des disques 26.

Si la plaquette était parfaitement plane, cette image 24 serait constituée des disques 25 représentés en traits fins. Elle serait l'image parfaite du motif d'éclairage.

Si la plaquette est déformée, cette image est déformée et elle est constituée des disques 26 représentés en traits gras. Il est possible, en analysant l'image par des moyens d'analyse d'image 40 de connaître avec une grande précision, supérieure à celle de la matrice de photodétection, les positions des centres de chaque image 26 de chaque point lumineux 22.

On peut utiliser, à cet effet, les techniques dites d' « upscaling » ou de changement de résolution qui permettent d'augmenter artificiellement la résolution de l'image. Typiquement, le grandissement de l'upscaling est de huit pour ce type d'application.

Par conséquent, il est possible de connaître dans un repère bidimensionnel (X, Y), comme on le voit sur la figure 3, très précisément les distances $x_1$ en X et $y_1$ en Y entre les points lumineux 26 à un temps t1 et de les comparer aux distances $x_0$ et $y_0$ obtenues entre les points lumineux 25 à un temps t0 sur une surface de référence. Les rapports entre les moyennes de ces distances donnent accès aux grandissements dans des directions déterminées. Les principes d'optique géométrique permettent de déduire les déformations à partir de la mesure de ces grandissements. En utilisant les mêmes principes d'optique, l'étude des grandissements dans plusieurs directions permet de déduire l'anisotropie de la déformation. En ajoutant la propriété d'invariance de la brillance avec l'angle d'incidence, on peut appliquer ces principes quel que soit l'angle entre le motif d'éclairage et la normale à la surface de la plaquette.

Les traitements d'image nécessitent des moyens de calcul informatiques tant au niveau des ressources de calcul que des moyens de mémorisation totalement compatibles avec les performances des ordinateurs de bureau actuels et peuvent être effectués en temps réel, c'est-à-dire dans l'intervalle de temps séparant deux mesures, soit quelques centièmes de seconde.

Les déformations mesurées sont celles de la zone éclairée 11 de la plaquette par le motif d'éclairage. Si la plaquette a des dimensions importantes, cette zone ne couvre que partiellement la plaquette 10. Aussi, le dispositif de mesure selon l'invention comporte des moyens de réalisation d'au moins deux mesures, chaque mesure comportant l'émission d'un motif d'éclairage, lesdits moyens de réalisation des deux mesures étant agencés de façon que le premier motif d'éclairage associé à la première mesure éclaire une première zone de la plaquette différente de la seconde zone de la plaquette éclairée par le second motif d'éclairage associé à la seconde mesure, la caméra étant fixe entre les deux mesures. Une alternative est la cartographie de la courbure par l'utilisation d'un réseau de spots fixes couvrant tout l'écran et dont l'image couvre toute la surface d'étude.

Dans le cas présent, le dispositif de mesure comporte un plateau tournant 50 disposé sous la plaquette 10. L'axe de rotation de ce plateau est parallèle à la normale à la surface de la plaquette. L'intérêt de cette disposition est que, pour des raisons d'homogénéisation des couches déposées, la plupart des enceintes à vide comportent d'office ce type de plateau tournant. Ainsi, pour réaliser une cartographie complète de la plaquette, il suffit d'enregistrer une série de mesures correspondant à différents angles de rotation de la plaquette. Si la déformation de la plaquette est homogène et isotrope, le dispositif de mesure permet de mesurer en continu la déformation, avec une sensibilité identique à celle obtenue avec une plaquette fixe, et ce malgré la mise en rotation.

Dans les conditions typiques de dépôts de films minces d'atomes sur la plaquette, pour conserver la sensibilité à l'échelle de la monocouche tout en moyennant la mesure pour optimiser le rapport signal sur bruit, la caméra doit avoir une fréquence d'acquisition de 10 Hz au minimum.

Il est nécessaire de connaître précisément la position de la plaquette à l'instant de la mesure. Différentes techniques sont possibles pour déterminer cette position. Une technique possible consiste à réaliser un étalonnage de la plaquette avant dépôt. Cet étalonnage présente l'intérêt d'enregistrer l'ensemble des défauts du système. Ainsi, pendant les mesures, les écarts mesurés correspondent uniquement aux déformations induites par le dépôt sur la plaquette.

A titre d'exemple, si le plateau tourne à une vitesse de 12 tours/mn et si la caméra réalise des mesures à la cadence de 30 enregistrements par seconde, on réalise ainsi une série d'enregistrements correspondant à des zones séparées de 2.4 degrés. Ces zones étant angulairement proches, il est alors possible, par interpolation entre deux angles successifs de référencer parfaitement la courbure à tout angle de rotation du plateau tournant. Toute mesure réalisée par la suite pourra, grâce à la connaissance de l'angle à laquelle elle est réalisée, être comparée à la valeur de référence au même angle, déduite de l'interpolation.

Le mouvement de rotation de la plaquette est bien adapté à la caractérisation « in-situ », c'est-à-dire pendant le dépôt des couches sur la plaquette.

On peut également réaliser des mouvements de translation de la plaquette dans son plan de façon à réaliser une caractérisation complète de la plaquette. Là encore, il suffit de parfaitement connaître les déplacements linéaires de la plaquette, soit par la mesure directe du déplacement, soit par des caractérisations préalables. La mesure par déplacements linéaires est bien adaptée à la caractérisation soit de plaquettes vierges de façon à déterminer leur planéité avant dépôt, soit de plaquettes terminées de façon à contrôler leur état de surface après dépôt. Un des principaux avantages de cette technique est que les mesures peuvent être réalisées hors des enceintes à vide « ex-situ », dans un environnement beaucoup moins contraignant que celui des enceintes à vide.

Un des intérêts de réaliser des mesures en continu est que, même si l'image du motif est très déformée en cas de déformations importantes de la plaquette, il est toujours possible de suivre l'évolution de cette déformation de façon qu'il n'y ait jamais d'ambiguïté sur les points mesurés.

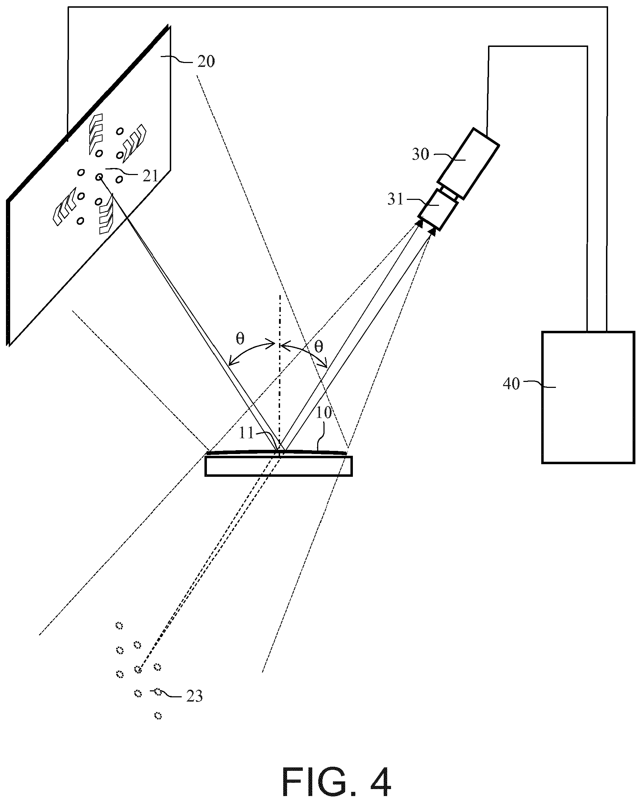

A titre de second exemple non limitatif, la figure 4 représente un second mode de réalisation du dispositif de mesure selon l'invention des déformations d'une plaquette 10. On a utilisé les mêmes notations sur cette figure 4 que celles de la figure 1. La caméra utilisée est de même nature. Dans ce second mode, la plaquette 10 reste fixe. Pour obtenir le déplacement des zones de mesure, on déplace le motif d'éclairage. Il existe différentes méthodes pour réaliser ce déplacement du motif. La méthode la plus simple et la plus reproductible consiste à déplacer le motif sur un écran de visualisation. Ce déplacement est symbolisé par des chevrons disposés dans deux axes différents sur la figure 4. Ainsi, dans cette configuration, aucune pièce mécanique n'est mobile. Par ailleurs, il est facile non seulement de déplacer le motif d'éclairage, mais il est également possible de le dupliquer ou de l'agrandir ou de le modifier. Il est également aisé de connaître parfaitement les positions sur l'écran de visualisation des points lumineux constituant le motif d'éclairage. La luminosité et la résolution des écrans de visualisation actuels sont suffisantes pour réaliser des motifs lumineux et de petite dimension. A titre d'exemple, la luminance des spots est comprise entre 200 et 500 cd/m$^2$ et la résolution moyenne de l'écran est entre 100 et 500 DPI ou « Dots Per Inch ».

Là encore, en réalisant une série de mesures, on détermine la cartographie complète des déformations de la plaquette.

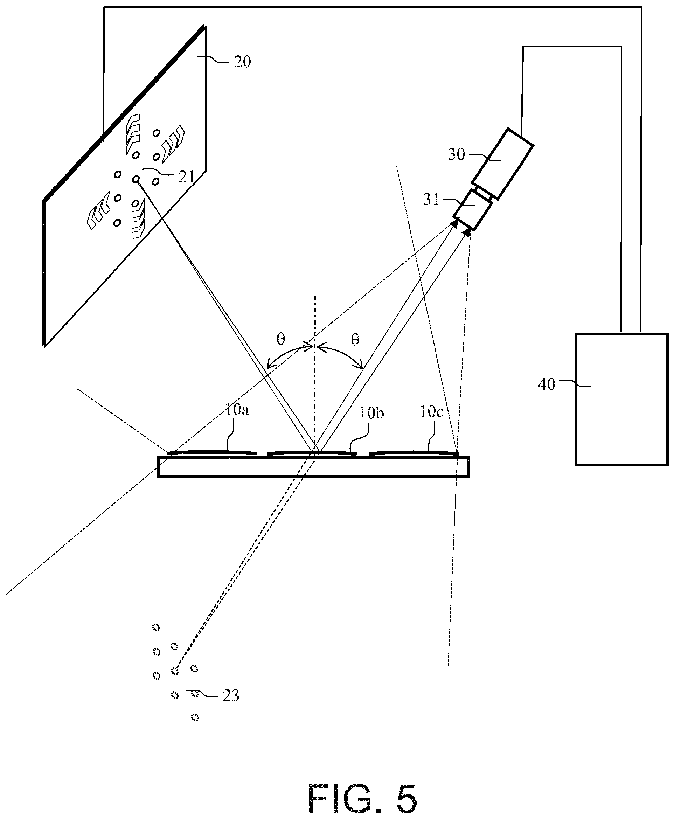

Dans une variante représentée en figure 5, il est possible de mesurer plusieurs plaquettes 10a, 10b et 10c dans une même série de mesures, par exemple, pour réaliser le contrôle de la reproductibilité des opérations de dépôt. Ce type de contrôle est normalement réalisé ex-situ dans des conditions environnementales plus favorables.

Comme on le voit sur les figures 1, 4 et 5, tant que l'angle d'incidence $\theta$ des faisceaux d'émission conserve une certaine valeur, par exemple supérieure à quelques degrés, la partie générant le motif d'éclairage est naturellement disjointe de la caméra de réception. Il n'en va pas de même lorsque cet angle d'incidence $\theta$ est faible ou nul, c'est-à-dire lorsque les mesures sont réalisées en incidence normale ou quasi-normale sur la plaquette.

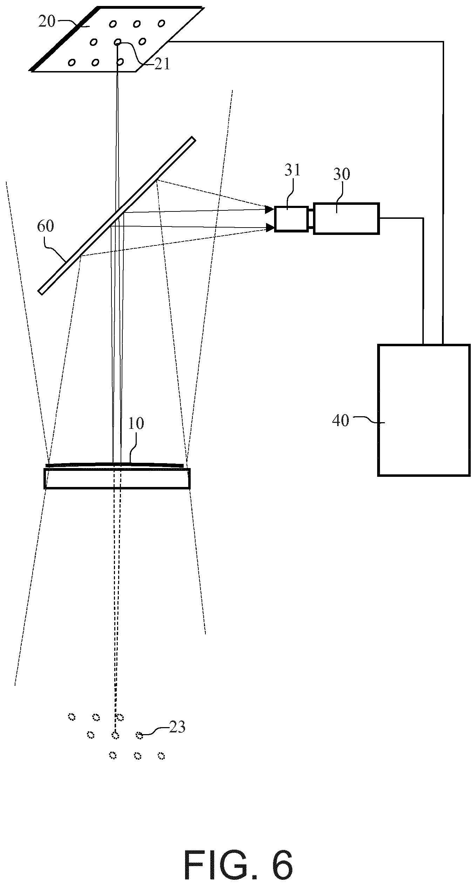

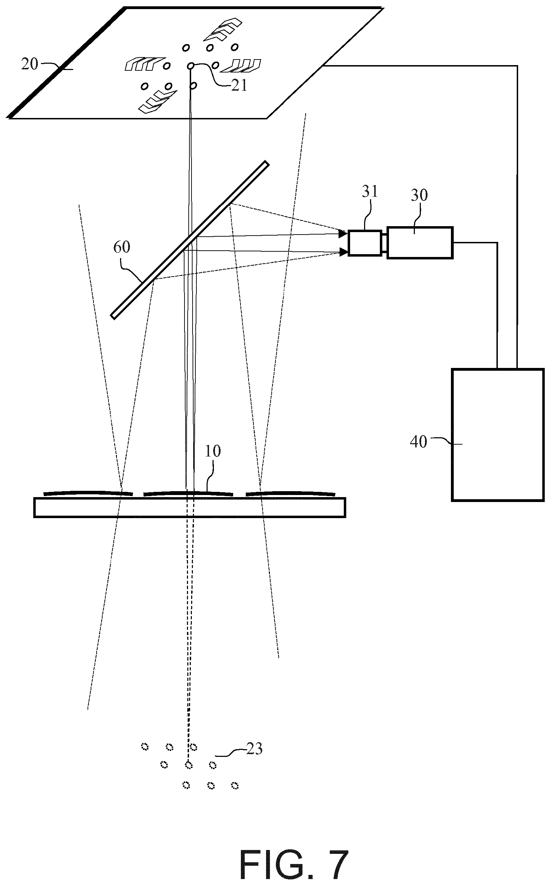

Pour résoudre ce problème, le dispositif de mesure comporte un séparateur optique plan semi-réfléchissant comme on le voit sur les figures 6 et 7. Ce séparateur 60 est agencé de façon que l'image du motif de points, après transmission par le séparateur optique, réflexion sur la plaquette et réflexion sur ledit séparateur optique se forme sur le détecteur de la caméra. On peut également inverser motif d'éclairage et caméra. Dans ce cas, l'image du motif de points après réflexion sur ledit séparateur optique, réflexion sur la plaquette et transmission par ledit séparateur optique se forme sur le détecteur de la caméra.

Bien entendu, il est possible avec ce montage d'obtenir des déplacements de la zone de mesure soit par des déplacements du motif d'éclairage sur un écran de visualisation, comme on le voit sur la figure 7, soit par des déplacements ou des rotations de la plaquette.

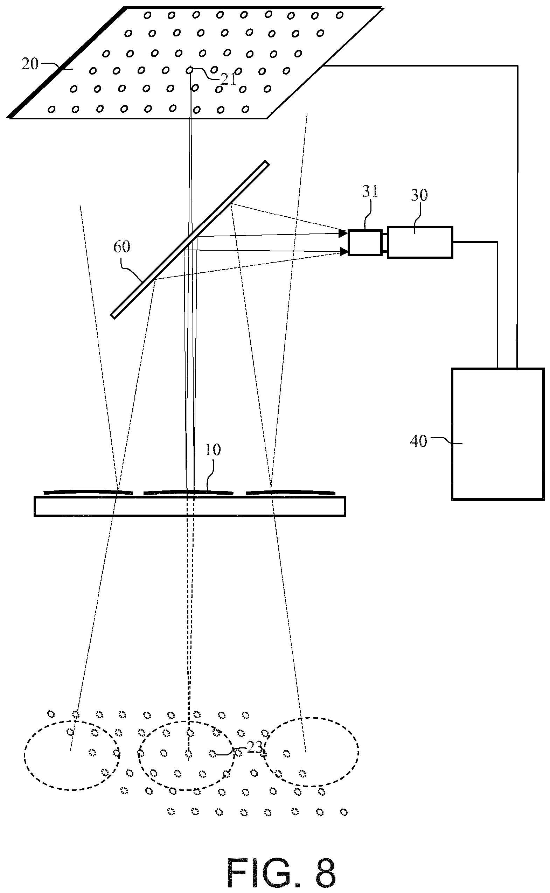

Il est également, possible, comme indiqué sur la figure 8, de réaliser simultanément le contrôle de plusieurs plaquettes en utilisant un dispositif d'éclairage dont le motif d'éclairage est de grandes dimensions et comporte un grand nombre de points d'éclairage, et d'obtenir une cartographie de la déformation instantanée.

On a vu que, dans le cas de surfaces planes ou faiblement courbées, qu'il est possible d'augmenter la sensibilité du dispositif en augmentant l'angle d'incidence, la sensibilité étant exacerbée en incidence rasante. Il existe un second moyen d'augmenter la sensibilité du dispositif, cette fois-ci lorsque la surface réfléchissante est courbe. Le dispositif de mesure selon l'invention permet de mesurer la courbure d'une surface réfléchissante en observant la déformation de l'image d'un objet à travers cette surface. A cet effet, on mesure le grandissement entre l'image du motif d'éclairage et le motif d'éclairage lui-même. Pour une déformation de la surface réfléchissante donnée, plus la variation de grandissement est grande, plus le dispositif de mesure est sensible. Il est donc intéressant de rechercher les configurations permettant d'obtenir la meilleure sensibilité au grandissement. Ces configurations sont obtenues lorsque l'image du motif est située au voisinage de l'optique de la caméra. Cette condition ne peut être obtenue que pour des surfaces réfléchissantes concaves. Dans ce cas, si on note d la distance du motif au centre de la surface réfléchissante, d' la distance de la lentille de la caméra à ce même centre, R le rayon de courbure de la surface, pour que la sensibilité au grandissement soit maximale, il est nécessaire que les distances d et d' vérifient l'équation :

$$d.d'/(d+d') = R/2$$

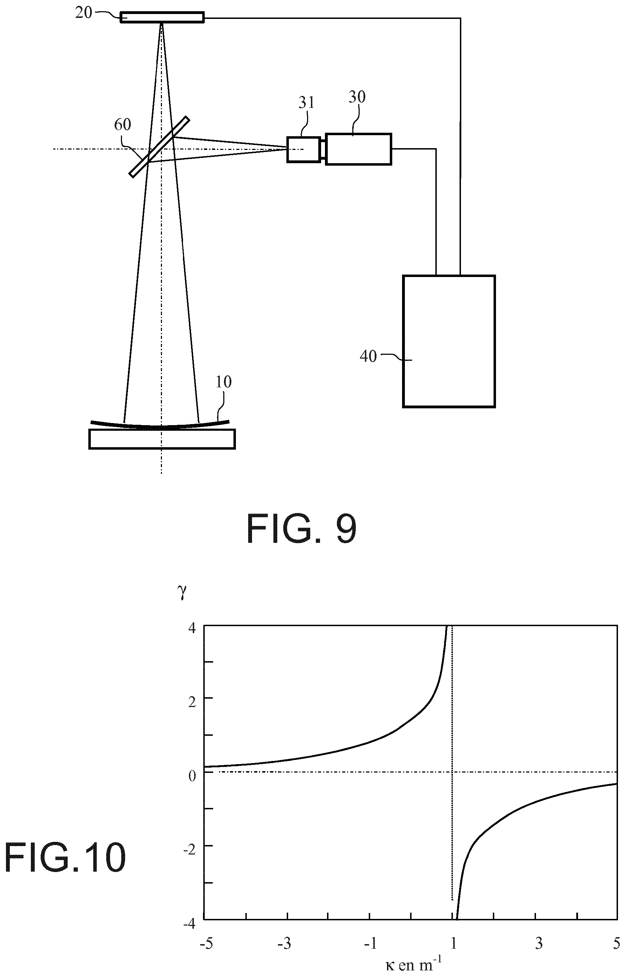

Une configuration simple qui permet d'obtenir cette grande sensibilité du grandissement est de disposer le motif d'éclairage au centre de courbure de la surface réfléchissante. Cette disposition est représentée sur la figure 9. Sur cette figure, les références utilisées sont identiques à celles des figures précédentes. Dans ce cas, la distance d est égale au rayon R de la surface réfléchissante 10 et la distance d' est également égale à ce même rayon R pour séparer les rayons lumineux émis par le motif des rayons réfléchis par la surface réfléchissante 10, on utilise une lame semi-réfléchissante 60 comme dans les précédents dispositifs des figures 6, 7 et 8.

La courbe de la figure 10 représente les variations du grandissement γ en fonction de la courbure κ de la surface pour des distances d et d' égales à un mètre. Sur la figure 10, la courbure κ varie entre -5 et +5 et le grandissement entre -4 et +4. Lorsque la courbure κ de la surface est égale à un mètre, c'est-à-dire lorsque son rayon de courbure est égal à un mètre, l'équation précédente est vérifiée et le grandissement γ diverge comme on le voit sur la figure 10. On obtient alors la sensibilité maximale. Toute variation du rayon de courbure autour de cette valeur entraînera une variation très importante du grandissement.

Cette dernière disposition ne peut fonctionner qu'avec une surface réfléchissante concave. Dans le cas de plaquettes de semi-conducteurs, il est possible d'utiliser une plaquette plane que l'on va précontraindre de façon à obtenir la courbure souhaitée. On peut obtenir facilement cette contrainte en effectuant, par exemple, un dépôt sur la face arrière qui va courber la plaquette. Un dépôt en face avant introduisant une faible variation du rayon de courbure entraînera une importante variation du grandissement vu par la caméra.

De façon générale, plus l'objet lumineux et la caméra sont éloignées de la surface réfléchissante, meilleure est la sensibilité du dispositif de mesure.

La courbure de la surface réfléchissante n'est pas nécessairement la même dans toutes les directions. Cela se produit notamment lorsque l'on dépose un film cristallin sur une plaquette de semi-conducteur. Par exemple, lors de la croissance cristalline d'un matériau anisotrope, on observe une anisotropie de déformation avec une direction plus courbée que l'autre. Lorsque le motif lumineux est composé de points lumineux distincts tels que représentés sur les figures 2 à 8, l'information d'anisotropie est obtenue simultanément dans deux directions orthogonales pour chaque image analysée. Cependant, une seule image est insuffisante pour déterminer les axes d'anisotropie. Il est nécessaire d'effectuer une rotation complète de la plaquette autour de son axe pour déterminer les axes d'anisotropie.

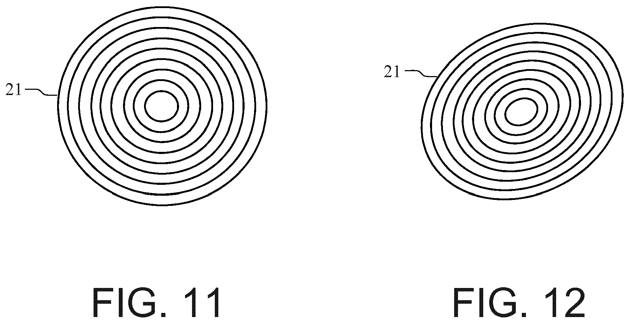

Pour déterminer l'information d'anisotropie, bien que non revendiqué, on peut utiliser un motif lumineux mieux adapté que la matrice de points lumineux. Ainsi, si on utilise, comme motif, un cercle lumineux ou une ellipse lumineuse ou encore une série de cercles concentriques ou une série d'ellipses concentriques, on peut alors déterminer au moyen d'une seule image toutes les informations de déformation de la plaquette. La figure 11 représente un motif d'éclairage 21 de ce type composé de neuf cercles concentriques lumineux et la figure 12 représente l'image de ces cercles concentriques après réflexion sur la plaquette réfléchissante. La déformation elliptique de ces cercles ainsi que l'inclinaison des axes des ellipses est représentative de l'anisotropie de la plaquette réfléchissante.

Ces motifs lumineux circulaires ou elliptiques ne posent aucun problème particulier de réalisation.

## Revendications

1. Procédé de mesure de la déformation d'au moins une surface réfléchissante (10) d'un objet par un dispositif de mesure, ledit dispositif de mesure comprenant au moins un motif d'éclairage (21) comprenant un ensemble de points lumineux (22) discrets répartis en matrice, une caméra (30, 31) et un dispositif d'analyse d'images (40),

   la lumière provenant des points lumineux étant réfléchie par la surface réfléchissante, la surface réfléchissante formant une image virtuelle du motif d'éclairage, l'image virtuelle créée par la surface réfléchissante étant localisée derrière ladite surface réfléchissante,
   le motif d'éclairage et la caméra étant agencés de façon qu'en position de mesure de la déformation de ladite surface, l'image (23) virtuelle du motif d'éclairage formée par réflexion dudit motif d'éclairage sur la surface réfléchissante soit visible par le détecteur (30) de la caméra,
   ladite image virtuelle étant représentative de la déformation de la zone éclairée (11) de la surface par le motif d'éclairage, la caméra étant configurée pour former une image finale (24) de ladite image (23) virtuelle du motif d'éclairage sur ledit détecteur (30) de la caméra,
   le procédé de réalisation d'une mesure comportant une étape d'analyse de ladite image finale comportant les sous-étapes suivantes :

   1. Mesure d'au moins une distance entre les images finales de deux points lumineux dudit motif d'éclairage;

2. Calcul du rapport entre cette distance mesurée à au moins une distance de référence entre lesdits deux points, la distance de référence étant mesurée lorsqu'une image virtuelle est formée par réflexion du motif d'éclairage sur une surface réfléchissante de référence ;

3. Calcul, à partir de ce rapport, du grandissement dans une direction déterminée ;

4. Calcul de la déformation de la surface réfléchissante dans ladite direction déterminée à partir du grandissement en appliquant les principes de l'optique géométrique,

l'étape d'analyse comprenant une cinquième sous-étape dans laquelle les sous étapes 1 à 4 sont mises en œuvre pour une pluralité d'images finales de points lumineux de façon à mesurer le grandissement dans une pluralité de directions déterminées, et à déterminer l'anisotropie de la déformation de la surface réfléchissante, une image finale permettant une détermination d'information d'anisotropie dans deux directions orthogonales, ladite pluralité d'images finales étant réalisées selon une pluralité de positions angulaires dudit objet décrivant une rotation complète dudit objet, de manière à déterminer un ou des axes d'anisotropie de la déformation de ladite surface.

2. Procédé de mesure selon la revendication 1, **caractérisé en ce que** le procédé comporte une étape de réalisation d'au moins une seconde mesure, cette seconde mesure comportant l'émission d'un second motif d'éclairage, lesdits moyens de réalisation des deux mesures étant agencés de façon que le premier motif d'éclairage associé à la première mesure éclaire une première zone de la surface différente de la seconde zone de la surface éclairée par le second motif d'éclairage associé à la seconde mesure, la caméra étant fixe entre les deux mesures.

3. Dispositif de mesure de la déformation d'au moins une surface réfléchissante (10) d'un objet, ledit dispositif de mesure comprenant :

- au moins un motif d'éclairage (21) comportant un ensemble de points lumineux (22) répartis en matrice,
- une caméra (30, 31) et
- un dispositif d'analyse d'images (40),
- des moyens de déplacement en rotation de l'objet dans un plan déterminé et des moyens de mesure dudit déplacement,
la lumière provenant des points lumineux étant réfléchie par la surface réfléchissante, la surface réfléchissante formant une image virtuelle du motif d'éclairage, l'image virtuelle créée par la surface réfléchissante étant localisée derrière ladite surface réfléchissante,

le motif d'éclairage et la caméra étant agencés de façon qu'en position de mesure de la déformation de ladite surface, l'image (23) virtuelle du motif d'éclairage formée par réflexion dudit motif d'éclairage sur la surface réfléchissante soit visible par le détecteur (30) de la caméra, la ladite image virtuelle étant représentative de la déformation de la zone éclairée (11) de la surface par le motif d'éclairage,

ladite caméra étant configurée pour former une image finale (24) de ladite image (23) virtuelle du motif d'éclairage sur ledit détecteur (30), le dispositif d'analyse d'images comportant :

- Des moyens de mesure d'au moins une distance entre les images finales de deux points lumineux dudit motif d'éclairage ;
- Des premiers moyens de calcul du rapport entre cette distance mesurée à au moins une distance de référence entre lesdits deux points, la distance de référence étant mesurée lorsqu'une image virtuelle est formée par réflexion du motif d'éclairage sur une surface réfléchissante de référence ;
- Des seconds moyens de calcul, à partir de ce rapport, du grandissement dans une direction déterminée ;
- Des troisièmes moyens de calcul de la déformation de la surface réfléchissante dans ladite direction déterminée à partir du grandissement en appliquant les principes de l'optique géométrique ;
- Les moyens de mesure et de calcul étant en outre configurés pour traiter une pluralité d'images finales de points lumineux de façon à mesurer le grandissement dans une pluralité de directions déterminées, et à déterminer en temps réel l'anisotropie de la déformation de la surface réfléchissante, une image finale permettant une détermination d'information d'anisotropie dans deux directions orthogonales, ladite pluralité d'images finales étant réalisées selon une pluralité de positions angulaires dudit objet décrivant une rotation complète dudit objet, de manière à déterminer un ou des axes d'anisotropie de la déformation de ladite surface.

4. Dispositif de mesure selon la revendication 3, **caractérisé en ce que** le dispositif comporte des moyens de réalisation d'au moins deux mesures, chaque mesure comportant l'émission d'un motif d'éclairage, lesdits moyens de réalisation des deux mesures étant agencés de façon que le premier motif d'éclairage associé à la première mesure éclaire une première zone de la surface différente de la seconde zone de la surface éclairée par le second motif d'éclairage associé à la seconde mesure, la caméra étant fixe entre les deux mesures.

**5.** Dispositif de mesure selon l'une des revendications 3 ou 4, **caractérisé en ce que** le dispositif de mesure comporte des moyens de déplacement, de déformation ou de grandissement du motif d'éclairage.

**6.** Dispositif de mesure selon l'une des revendications 3 à 5, comportant en outre des moyens de déplacement (50) en translation de l'objet dans un plan déterminé et des moyens de mesure dudit déplacement.

**7.** Dispositif de mesure selon l'une des revendications 3 à 6, **caractérisé en ce que** le dispositif de mesure comporte un écran de visualisation (20) et des moyens de génération graphique dudit motif d'éclairage sur ledit écran de visualisation.

**8.** Dispositif de mesure selon l'une des revendications 3 à 7, **caractérisé en ce que** le dispositif de mesure comporte une source d'éclairage éclairant un écran opaque comportant des ouvertures agencées de façon à former un motif d'éclairage.

**9.** Dispositif de mesure selon l'une des revendications 3 à 8, **caractérisé en ce que** le dispositif de mesure comporte un séparateur optique (60) plan semi-réfléchissant agencé de façon que l'image du motif de points, après transmission par ledit séparateur optique, réflexion sur la surface et réflexion sur ledit séparateur optique se forme sur le détecteur de la caméra ou après réflexion sur ledit séparateur optique, réflexion sur la surface et transmission par ledit séparateur optique se forme sur le détecteur de la caméra.

**10.** Dispositif de mesure selon l'une des revendications 3 à 9, **caractérisé en ce que** le dispositif de mesure comporte des moyens de réalisation d'une pluralité de mesures configurés pour réaliser une cartographie complète de la déformation de ladite surface.

**11.** Dispositif de mesure selon l'une des revendications 3 à 10, **caractérisé en ce que** le rayon de courbure local, concave ou convexe, des déformations varie entre quelques millimètres et quelques dizaines de kilomètres.

**12.** Dispositif de mesure selon l'une des revendications 3 à 11, **caractérisé en ce que** l'objet est une plaquette de semi-conducteur ou « wafer », la surface réfléchissante étant l'une des faces de ladite plaquette.

**13.** Utilisation d'un dispositif de mesure selon l'une des revendications 3 à 12 pour le suivi d'un traitement entrainant une déformation de la surface réfléchissante d'un objet dans un bâti de croissance, **caractérisé en ce que** les mesures sont effectuées pendant le dépôt d'au moins une couche de matériau sur ladite surface réfléchissante.

**14.** Utilisation d'un dispositif de mesure selon l'une des revendications 3 à 12 dans un dispositif de contrôle de plaquettes de semi-conducteurs, **caractérisé en ce que** les mesures sont effectuées en continu sur au moins deux objets différents.

**Patentansprüche**

**1.** Verfahren zur Messung der Verformung mindestens einer reflektierenden Oberfläche (10) eines Objekts durch eine Messvorrichtung, wobei die Messvorrichtung mindestens ein Beleuchtungsmuster (21) umfasst, das eine Anordnung von diskreten, in einer Matrix verteilten Lichtpunkten (22) umfasst, eine Kamera (30, 31) und eine Bildanalysevorrichtung (40),

wobei das von den Lichtpunkten kommende Licht von der reflektierenden Oberfläche reflektiert wird, wobei die reflektierende Oberfläche ein virtuelles Bild des Beleuchtungsmusters bildet, wobei das von der reflektierenden Oberfläche erzeugte virtuelle Bild hinter der reflektierenden Oberfläche lokalisiert ist, wobei das Beleuchtungsmuster und die Kamera so angeordnet sind, dass in der Messposition der Verformung der Oberfläche das virtuelle Bild (23) des Beleuchtungsmusters, das durch Reflexion des Beleuchtungsmusters auf der reflektierenden Oberfläche gebildet wird, für den Detektor (30) der Kamera sichtbar ist, wobei das virtuelle Bild die Verformung der beleuchteten Zone (11) der Oberfläche durch das Beleuchtungsmuster darstellt, wobei die Kamera dazu konfiguriert ist, ein finales Bild (24) des virtuellen Bildes (23) des Beleuchtungsmusters auf dem Detektor (30) der Kamera zu bilden, wobei das Verfahren zur Ausführung einer Messung einen Schritt des Analysierens des finalen Bildes umfasst, der die folgenden Teilschritte umfasst:

1. Messen mindestens eines Abstands zwischen den finalen Bildern zweier Lichtpunkte des Beleuchtungsmusters;
2. Berechnen des Verhältnisses zwischen diesem Abstand, gemessen in mindestens einem Referenzabstand zwischen den zwei Punkten, wobei der Referenzabstand gemessen wird, wenn ein virtuelles Bild durch Reflexion des Beleuchtungsmusters auf einer reflektierenden Referenzoberfläche gebildet wird;

3. Berechnen der Vergrößerung in einer festgelegten Richtung anhand dieses Verhältnisses;

4. Berechnen der Verformung der reflektierenden Oberfläche in der festgelegten Richtung, die anhand der Vergrößerung unter Anwendung der Prinzipien der geometrischen Optik bestimmt wird, wobei der Analyseschritt einen fünften Teilschritt umfasst, in dem die Teilschritte 1 bis 4 für eine Vielzahl von finalen Bildern von Lichtpunkten implementiert werden, um die Vergrößerung in einer Vielzahl von festgelegten Richtungen zu messen und die Anisotropie der Verformung der reflektierenden Oberfläche zu bestimmen, wobei ein finales Bild eine Bestimmung von Anisotropieinformationen in zwei orthogonalen Richtungen ermöglicht, wobei die Vielzahl von finalen Bildern in einer Vielzahl von Winkelstellungen des Objekts ausgeführt wird, die eine vollständige Drehung des Objekts beschreiben, um eine oder mehrere Anisotropieachsen der Verformung der Oberfläche zu bestimmen.

**2.** Messverfahren nach Anspruch 1, **dadurch gekennzeichnet, dass** das Verfahren einen Schritt des Ausführens mindestens einer zweiten Messung umfasst, wobei diese zweite Messung das Aussenden eines zweiten Beleuchtungsmusters umfasst, wobei die Mittel zur Ausführung der zwei Messungen so angeordnet sind, dass das erste Beleuchtungsmuster, das der ersten Messung zugeordnet ist, eine erste Zone der Oberfläche beleuchtet, die sich von der zweiten Zone der Oberfläche unterscheidet, die durch das zweite Beleuchtungsmuster beleuchtet wird, das der zweiten Messung zugeordnet ist, wobei die Kamera zwischen den beiden Messungen feststehend ist.

**3.** Vorrichtung zur Messung der Verformung mindestens einer reflektierenden Oberfläche (10) eines Objekts, wobei die Messvorrichtung umfasst:

- mindestens ein Beleuchtungsmuster (21), das eine Anordnung von in einer Matrix verteilten Lichtpunkten (22) umfasst,
- eine Kamera (30, 31) und
- eine Bildanalysevorrichtung (40),
- Mittel zur Drehbewegung des Objekts in einer festgelegten Ebene und Mittel zur Messung dieser Bewegung,

wobei das von den Lichtpunkten kommende Licht von der reflektierenden Oberfläche reflektiert wird, wobei die reflektierende Oberfläche ein virtuelles Bild des Beleuchtungsmusters bildet, wobei das von der reflektierenden Oberfläche erzeugte virtuelle Bild hinter der reflektierenden Oberfläche lokalisiert ist, wobei das Beleuchtungsmuster und die Kamera so angeordnet sind, dass in der Messposition der Verformung der Oberfläche das virtuelle Bild (23) des Beleuchtungsmusters, das durch Reflexion des Beleuchtungsmusters auf der reflektierenden Oberfläche gebildet wird, für den Detektor (30) der Kamera sichtbar ist, wobei das virtuelle Bild die Verformung der beleuchteten Zone (11) der Oberfläche durch das Beleuchtungsmuster darstellt, wobei die Kamera dazu konfiguriert ist, ein finales Bild (24) des virtuellen Bildes (23) des Beleuchtungsmusters auf dem Detektor (30) zu bilden, wobei die Bildanalysevorrichtung umfasst:

- Mittel zum Messen mindestens eines Abstands zwischen den finalen Bildern zweier Lichtpunkte des Beleuchtungsmusters;
- Erste Mittel zur Berechnung des Verhältnisses zwischen diesem Abstand, gemessen in mindestens einem Referenzabstand zwischen den zwei Punkten, wobei der Referenzabstand gemessen wird, wenn ein virtuelles Bild durch Reflexion des Beleuchtungsmusters auf einer reflektierenden Referenzoberfläche gebildet wird;
- Zweite Mittel zur Berechnung der Vergrößerung in einer festgelegten Richtung anhand dieses Verhältnisses;
- Dritte Mittel zur Berechnung der Verformung der reflektierenden Oberfläche in der festgelegten Richtung, die anhand der Vergrößerung unter Anwendung der Prinzipien der geometrischen Optik bestimmt wird;
- Wobei die Mess- und Berechnungsmittel weiter dazu konfiguriert sind, eine Vielzahl von finalen Bildern von Lichtpunkten so zu verarbeiten, dass die Vergrößerung in einer Vielzahl von festgelegten Richtungen gemessen wird, und die Anisotropie der Verformung der reflektierenden Oberfläche in Echtzeit bestimmt wird, wobei ein finales Bild eine Bestimmung von Anisotropieinformationen in zwei orthogonalen Richtungen ermöglicht, wobei die Vielzahl von finalen Bildern in einer Vielzahl von Winkelstellungen des Objekts ausgeführt wird, die eine vollständige Drehung des Objekts beschreiben, um eine oder mehrere Anisotropieachsen der Verformung der Oberfläche zu bestimmen.

4. Messvorrichtung nach Anspruch 3, **dadurch gekennzeichnet, dass** die Vorrichtung Mittel zur Ausführung von mindestens zwei Messungen umfasst, wobei jede Messung das Aussenden eines Beleuchtungsmusters umfasst, wobei die Mittel zur Ausführung der zwei Messungen so angeordnet sind, dass das erste Beleuchtungsmuster, das der ersten Messung zugeordnet ist, eine erste Zone der Oberfläche beleuchtet, die sich von der zweiten Zone der Oberfläche unterscheidet, die durch das zweite Beleuchtungsmuster beleuchtet wird, das der zweiten Messung zugeordnet ist, wobei die Kamera zwischen den zwei Messungen feststehend ist.

5. Messvorrichtung nach einem der Ansprüche 3 oder 4, **dadurch gekennzeichnet, dass** die Messvorrichtung Mittel zum Bewegen, Verformen oder Vergrößern des Beleuchtungsmusters umfasst.

6. Messvorrichtung nach einem der Ansprüche 3 bis 5, die weiter Mittel (50) zur translatorischen Bewegung des Objekts in einer festgelegten Ebene und Mittel zur Messung dieser Bewegung umfasst.

7. Messvorrichtung nach einem der Ansprüche 3 bis 6, **dadurch gekennzeichnet, dass** die Messvorrichtung einen Visualisierungschirm (20) und Mittel zum grafischen Erzeugen des Beleuchtungsmusters auf dem Visualisierungschirm umfasst.

8. Messvorrichtung nach einem der Ansprüche 3 bis 7, **dadurch gekennzeichnet, dass** die Messvorrichtung eine Beleuchtungsquelle umfasst, die einen opaken Bildschirm beleuchtet, der Öffnungen umfasst, die so angeordnet sind, dass sie ein Beleuchtungsmuster bilden.

9. Messvorrichtung nach einem der Ansprüche 3 bis 8, **dadurch gekennzeichnet, dass** die Messvorrichtung einen flachen, halbreflektierenden optischen Teiler (60) umfasst, der so angeordnet ist, dass sich das Bild des Punktmusters nach der Übertragung durch den optischen Teiler, der Reflexion auf der Oberfläche und der Reflexion auf dem optischen Teiler auf dem Detektor der Kamera bildet oder sich nach der Reflexion auf dem optischen Teiler, der Reflexion auf der Oberfläche und der Übertragung durch den optischen Teiler auf dem Detektor der Kamera bildet.

10. Messvorrichtung nach einem der Ansprüche 3 bis 9, **dadurch gekennzeichnet, dass** die Messvorrichtung Mittel zur Ausführung einer Vielzahl von Messungen umfasst, die dazu konfiguriert sind, eine vollständige Kartografie der Verformung der Oberfläche zu erstellen.

11. Messvorrichtung nach einem der Ansprüche 3 bis 10, **dadurch gekennzeichnet, dass** der lokale, konkave oder konvexe Krümmungsradius der Verformungen zwischen einigen Millimetern und einigen Dutzend Kilometern variiert.

12. Messvorrichtung nach einem der Ansprüche 3 bis 11, **dadurch gekennzeichnet, dass** das Objekt eine Halbleiterscheibe oder "Wafer" ist, wobei die reflektierende Oberfläche eine der Seiten dieser Scheibe ist.

13. Verwendung einer Messvorrichtung nach einem der Ansprüche 3 bis 12 zur Überwachung einer Bearbeitung, die eine Verformung der reflektierenden Oberfläche eines Objekts in einem Wachstumsgestell bewirkt, **dadurch gekennzeichnet, dass** die Messungen während der Abscheidung mindestens einer Materialschicht auf der reflektierenden Oberfläche durchgeführt werden.

14. Verwendung einer Messvorrichtung nach einem der Ansprüche 3 bis 12 in einer Steuervorrichtung für Halbleiterscheiben, **dadurch gekennzeichnet, dass** die Messungen kontinuierlich auf mindestens zwei verschiedenen Objekten erfolgen.

## Claims

1. Method for measuring the deformation of a reflective surface (10) of an object by a measurement device, said measurement device comprising at least one lighting pattern (21) comprising an assembly of discrete light points (22) distributed in a matrix, a camera (30, 31) and an image-analysis device (40),

> the light coming from light points being reflected by the reflective surface, the reflective surface forming a virtual image of the lighting pattern, the virtual image created by the reflective surface being located behind said reflective surface, the lighting pattern and the camera being arranged so that, in the position for measuring the deformation of said surface, the virtual image (23) of the lighting pattern formed by reflection of said lighting pattern on the reflective surface is visible by the detector (30) of the camera,

said virtual image being representative of the deformation of the illuminated zone (11) of the surface by the lighting pattern, the camera being configured to form a final image (24) of said virtual image (23) of the lighting pattern on said detector (30) of the camera,

the method for taking a measurement comprising a step of analyzing said final image comprising the following substeps:

1. Measuring at least one distance between the final images of two light points of said lighting pattern;

2. Calculating the ratio between this measured distance and at least one reference distance between said two points, the reference distance being measured when a virtual image is formed by reflection of the lighting pattern on a reference reflective surface;

3. Calculating, from this ratio, the magnification in a determined direction;

4. Calculating the deformation of the reflective surface in said direction determined from the magnification by applying the principles of geometric optics, the analysis step comprising a fifth substep in which substeps 1 to 4 are implemented for a plurality of final images of light points, so as to measure the magnification in a plurality of determined directions, and to determine the anisotropy of the deformation of the reflective surface, a final image enabling an anisotropy information determination in two orthogonal directions, said plurality of final images being made along a plurality of angular positions of said object describing a complete rotation of said object, so as to determine one or more anisotropy axes of the deformation of said surface.

2. Measuring method according to claim 1, **characterized in that** the method comprises a step of taking at least one second measurement, this second measurement comprising the emission of a second lighting pattern, said means for taking two measurements being arranged, so that the first lighting pattern associated with the first measurement illuminates a first zone of the different surface of the second zone of the illuminated surface by the second lighting pattern associated with the second measurement, the camera being fixed between the two measurements.

3. Device for measuring the deformation of at least one reflective surface (10) of an object, said measuring device comprising:

- at least one lighting pattern (21) comprising an assembly of light points (22) distributed in a matrix,
- a camera (30, 31) and
- an image analysis device (40),
- means for rotating the object in a determined plane and means for measuring said movement, the light coming from light points being reflected by the reflective surface, the reflective surface forming a virtual image of the lighting pattern, the virtual image created by the reflective surface being located behind said reflective surface,
the lighting pattern and the camera being arranged so that, in the position for measuring the deformation of said surface, the virtual image (23) of the lighting pattern formed by reflection of said lighting pattern on the reflective surface is visible by the detector (30) of the camera, said virtual image being representative of the deformation of the illuminated zone (11) of the surface by the lighting pattern,
said camera being configured to form a final image (24) of said virtual image (23) of the lighting pattern on said detector (30), the image analysis device comprising:

- Means for measuring at least one distance between the final images of two light points of said lighting pattern;

- First means for calculating the ratio between this measured distance and at least one reference distance between said two points, the reference distance being measured when a virtual image is formed by reflection of the lighting pattern on a reference reflective surface;

- Second means for calculating, from this ratio, the magnification in a determined direction;

- Third means for calculating the deformation of the reflective surface in said direction determined from the magnification by applying the principles of geometric optics;

- The measurement and calculation means being further configured to process a plurality of final images of light points, so as to measure the magnification in a plurality of determined directions, and to determine, in real time, the anisotropy of the deformation of the reflective surface, a final image enabling an anisotropy information determination in two orthogonal directions, said plurality of final images being made along a plurality of angular positions of said object describing a complete rotation of said object, so as to determine one or more anisotropy axes of the deformation of said surface.

**4.** Measurement device according to claim 3, **characterized in that** the device comprises a means for taking at least two measurements, each measurement comprising the emission of a lighting pattern, said means for taking two measurements being arranged, so that the first lighting pattern associated with the first measurement illuminates a first zone of the different surface of the second zone of the illuminated surface by the second lighting pattern associated with the second measurement, the camera being fixed between the two measurements.

**5.** Measurement device according to any one of claims 3 or 4, **characterized in that** the measurement device comprises means for moving, deforming or magnifying the lighting pattern.

**6.** Measurement device according to any one of claims 3 to 5, further comprising means (50) for translatably moving the object in a determined plane and means for measuring said movement.

**7.** Measurement device according to any one of claims 3 to 6, **characterized in that** the measurement device comprising a viewing screen (20) and means for generating graphics of said lighting pattern on said viewing screen.

**8.** Measurement device according to any one of claims 3 to 7, **characterized in that** the measurement device comprises a lighting source, illuminating an opaque screen comprising openings arranged so as to form a lighting pattern.

**9.** Measurement device according to any one of claims 3 to 8, **characterized in that** the measurement device comprises a semi-reflective, flat, optical separator (60), arranged so that the image of the point pattern, after transmission by said optical separator, reflection on the surface and reflection on said optical separator is formed on the detector of the camera or after reflection on said optical separator, reflection on the surface and transmission by said optical separator is formed on the detector of the camera.

**10.** Measurement device according to any one of claims 3 to 9, **characterized in that** the measurement device comprises means for taking a plurality of measurements, configured to produce a complete mapping of the deformation of said surface.

**11.** Measurement device according to any one of claims 3 to 10, **characterized in that** the concave or convex local bend radius, of the deformations varies between a few millimeters and a few tens of kilometers.

**12.** Measurement device according to any one of claims 3 to 11, **characterized in that** the object is a semiconductor wafer, the reflective surface being one of the faces of said wafer.

**13.** Use of a measurement device according to any one of claims 3 to 12, for the monitoring of a treatment leading to a deformation of the reflective surface of an object in a growth frame, **characterized in that** the measurements are taken during the deposition of at least one material layer on said reflective surface.

**14.** Use of a measurement device according to any one of claims 3 to 12 in a device for controlling semiconductor wafers, **characterized in that** the measurements are taken continuously on at least two different objects.

FIG. 1

**FIG. 2**

**FIG. 3**

FIG. 4

FIG. 5

FIG. 6

FIG. 7

FIG. 8

FIG. 9

FIG.10

FIG. 11

FIG. 12

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5912738 A
- US 9070590 B
- FR 2842591

- WO 2016018260 A
- US 9138790 B
- US 2007146685 A